# EUROPÄISCHE PATENTSCHRIFT

(11) **EP 3 384 073 B1**
(45) Veröffentlichungstag und Bekanntmachung des Hinweises auf die Patenterteilung: **20.01.2021**
(21) Anmeldenummer: 16801197.1
(22) Anmeldetag: 24.11.2016
(51) Int. Cl.: C30B 25/12, C30B 29/06, H01L 21/67, H01L 21/673

(54) **VERFAHREN ZUR HERSTELLUNG EINER HALBLEITERSCHEIBE MIT EPITAKTISCHER SCHICHT IN EINER ABSCHEIDEKAMMER, VORRICHTUNG ZUR HERSTELLUNG EINER HALBLEITERSCHEIBE MIT EPITAKTISCHER SCHICHT UND HALBLEITERSCHEIBE MIT EPITAKTISCHER SCHICHT**
METHOD FOR PRODUCING A SEMICONDUCTOR WAFER HAVING AN EPITAXIAL LAYER IN A DEPOSITION CHAMBER, APPARATUS FOR PRODUCING A SEMICONDUCTOR WAFER HAVING AN EPITAXIAL LAYER, AND SEMICONDUCTOR WAFER HAVING AN EPITAXIAL LAYER
PROCÉDÉ POUR PRODUIRE UNE TRANCHE DE SEMI-CONDUCTEUR AVEC UNE COUCHE ÉPITACTIQUE DANS UNE CHAMBRE DE DEPÔT, DISPOSITIF POUR FABRIQUER UNE TRANCHE DE SEMI-CONDUCTEUR AVEC UNE COUCHE ÉPITACTIQUE ET TRANCHE DE SEMI-CONDUCTEUR AVEC UNE COUCHE ÉPITACTIQUE

(30) Priorität: 01.12.2015 DE 102015223807
(43) Veröffentlichungstag der Anmeldung: 10.10.2018
(73) Patentinhaber: Siltronic AG, 81737 München (DE)
(72) Erfinder: MOOS, Patrick, 84431 Heldenstein (DE); SCHAUER, Reinhard, 83410 Laufen (DE)
(74) Vertreter: Staudacher, Wolfgang
(86) Internationale Anmeldenummer: PCT/EP2016/078618
(87) Internationale Veröffentlichungsnummer: WO 2017/093102

(56) Entgegenhaltungen:
- EP-A1- 1 289 006
- WO-A1-2015/092525
- WO-A1-2016/111747
- US-A1- 2010 273 314
- US-A1- 2010 327 415
- US-A1- 2012 234 243

## Beschreibung

Gegenstand der Erfindung sind ein Verfahren zur Herstellung einer Halbleiterscheibe mit epitaktischer Schicht in einer Abscheidekammer und eine Vorrichtung zur Herstellung einer Halbleiterscheibe mit epitaktischer Schicht.

Die Herstellung einer Halbleiterscheibe mit epitaktischer Schicht erfolgt üblicherweise durch Abscheiden aus der Gasphase (chemical vapor deposition, CVD). Ein solches Verfahren umfasst das Ablegen einer Substratscheibe auf einem Suszeptor und das Durchleiten eines Abscheidegases durch eine Abscheidekammer bei hoher Temperatur. Die epitaktische Schicht wächst auf der vom Abscheidegas überstrichenen Oberfläche der Substratscheibe. Üblicherweise ist diese Oberfläche die oben liegende Fläche der horizontal liegenden Substratscheibe. Übliche Abscheidesysteme umfassen neben der Abscheidekammer, die zum Prozessieren einzelner Substratscheiben ausgelegt ist, mindestens eine Schleusenkammer (load lock chamber), von der eine Substratscheibe vor dem Abscheiden der epitaktischen Schicht in die Abscheidekammer transportiert wird und in die die Halbleiterscheibe mit epitaktischer Schicht nach dem Abschieden der epitaktischen Schicht transportiert wird, um sie dort abkühlen zu lassen. Der Transportvorgang erfolgt zweckmäßigerweise unter Verwendung eines rechnergesteuerten Transportwerkzeugs. Ein solches Abscheidesystem ist beispielsweise in der EP 0 800 203 A2 beschrieben.

In der US 2008/0 118 712 A1 ist ein Verfahren zur Herstellung einer Halbleiterscheibe mit epitaktischer Schicht beschrieben, bei dem ein zweiteiliger Suszeptor verwendet wird. Den einen Teil bildet ein Ring mit einer Ablagefläche zum Ablegen der Substratscheibe im Randbereich der Rückseite der Substratscheibe. Den anderen Teil bildet eine Bodenplatte, auf der der Ring während des Abscheidens einer epitaktischen Schicht liegt. US 6 316 361 beschreibt eine Ausführungsform, die einen Ring ohne Bodenplatte als Suszeptor vorsieht.

Bekannte Verfahren zur Herstellung einer Halbleiterscheibe mit epitaktischer Schicht in einer Abscheidekammer sind mit einer Reihe von Problemen konfrontiert. Diese betreffen beispielsweise die Rückseite der Substratscheibe. Die Rückseite der Substratscheibe ist die untere, dem Suszeptor zugewandte Oberfläche der Substratscheibe. Im Zuge des Ablegens der Substratscheibe auf dem Suszeptor liegt die Substratscheibe mit der Rückseite zwischenzeitlich auf Hebestiften (lift pins), die üblicherweise aus einem harten, temperaturbeständigen Material bestehen, dessen Wärmeausdehnungs-Verhalten verschieden ist von dem der Substratscheibe. Ist die Temperatur der Hebestifte verschieden von der Temperatur der Substratscheibe, was beispielsweise beim Beladen der Abscheidekammer mit einer Substratscheibe nach einer vorangegangenen Abscheidung der Fall ist, kann es zu einer Relativbewegung zwischen den Hebestiften und der Substratscheibe kommen. Infolge dessen kann die Substratscheibe aus einer konzentrischen Lage zum Suszeptor verschoben und/oder die Rückseite der Substratscheibe beschädigt werden und/oder es werden störende Partikel erzeugt. Selbst wenn eine solche Relativbewegung ausbleibt, lassen sich nach dem Beschichten der Substratscheibe Spuren auf der Halbleiterscheibe mit epitaktischer Schicht nachweisen, die auf Strukturen des Suszeptors hinweisen. Solche Spuren lassen sich auf der Rückseite oder auf der Vorderseite der Halbleiterscheibe mit epitaktischer Schicht nachweisen oder auf der Rückseite und der Vorderseite der Halbleiterscheibe mit epitaktischer Schicht. Die Oberfläche der epitaktischen Schicht ist auch die Oberfläche der Vorderseite der Halbleiterscheibe mit epitaktischer Schicht. Zu den erwähnten Strukturen gehören Bohrungen im Suszeptor, die den Hebestiften den Zugang zur Substratscheibe ermöglichen, sowie die Hebestifte selbst. Die davon verursachten Spuren können als Pin-Mark-Defekte nachgewiesen werden. Dass unter der Substratscheibe Bohrungen und Hebestifte angeordnet sind, wirkt sich während des Abscheidens einer epitaktischen Schicht auf das Temperaturfeld auf der Substratscheibe aus. Im Temperaturfeld gibt es Stellen mit niedrigerer Temperatur beziehungsweise höherer Temperatur als der durchschnittlichen Temperatur im Temperaturfeld, mit der Folge, dass an diesen Stellen weniger beziehungsweise mehr Material als beabsichtigt abgeschieden wird. Ursache der Gradienten im Temperaturfeld sind die Bohrungen und die Hebestifte, die Wärme besser oder weniger gut abführen als das sie umgebende Material des Suszeptors.

In WO 97/14 179 A1 ist ein System zum Prozessieren von Halbleiterscheiben beschrieben, das ohne Hebestifte auskommt. Zum Transport der Substratscheibe beziehungsweise der Halbleiterscheibe mit epitaktischer Schicht wird ein auf dem Bernoulli-Prinzip arbeitendes Handhabungswerkzeug verwendet. Nachteilig daran ist, dass die Halbleiterscheibe mit epitaktischer Schicht durch ein solches Handhabungswerkzeug im Bereich des Rands beschädigt wird. Wegen einer solchen Beschädigung besteht ein erhöhtes Risiko, dass die Halbleiterscheibe an der beschädigten Stelle bricht. Die Beschädigung wird verursacht, weil ein zwischen dem Handhabungswerkzeug und der Halbleiterscheibe mit epitaktischer Schicht fließender Gasstrom den Rand der Halbleiterscheibe mit epitaktischer Schicht gegen eine Begrenzung des Handhabungswerkzeugs drückt. Die verursachte Beschädigung ist beispielsweise durch Inspektion mit einem Konfokalmikroskop zu erkennen oder auf einer AFM-Aufnahme (atomic force microscope). In der WO 2010/ 015 694 A1 ist beispielsweise eine geeignete Vorrichtung zur Inspektion des Rands einer Halbleiterscheibe beschrieben.

In der WO 99/27 577 A1 ist eine Vorrichtung zum Prozessieren von Halbleiterscheiben beschrieben mit zweiteiliger Suszeptor-Einheit, die keine Hebestifte zum Anheben der Halbleiterscheibe mit epitaktischer Schicht aufweist, und mit einem Substrat-Transfer-System, das auf ein Handhabungswerkzeug, das nach dem Bernoulli-Prinzip arbeitet, verzichtet. Zwischen einem äußeren Teilstück und einem inneren Teilstück der Suszeptor-Einheit besteht ein Spalt. Ähnlich wie die erwähnten Bohrungen im Suszeptor repräsentiert der Spalt eine Struktur im Suszeptor, die sich störend auf das Temperaturfeld auf der Substratscheibe auswirkt. Dementsprechend bewirkt der Spalt der zweiteiligen Suszeptor-Einheit auf der Halbleiterscheibe mit epitaktischer Schicht eine, den Spalt abbildende Spur, die nachgewiesen werden kann.

In US 2012/234243 A1 ist ein Verfahren zum Verarbeiten eines oder mehrerer Substrate beschrieben. Es umfasst das Übertragen eines Substratträgers mit einem oder mehreren Substraten in ein Kammervolumen und das Kontaktieren eines Kantenrings mit einem Satz von Hubstiften zur Steuerung der Position des Substratträgers innerhalb des Kammervolumens.

In WO 2015/092525 A1 ist eine Reaktionskammer offenbart, in der eine epitaktische Schicht auf einem Substrat abgeschieden werden kann. Es ist eine Vorrichtung zum Beladen und Entladen der Reaktionskammer vorgesehen.

US 2010/327415 A1 beschäftigt sich mit einem Verfahren zur Herstellung einer Halbleiterscheibe aus Silizium mit einer epitaktischen Schicht. Es wird ein Suzeptor verwendet, der keine Kratzer auf der Rückseite der Halbleiterscheibe verursacht.

In US 2010/273314 A1 ist ein Substratträger beschrieben, der mit Substraten beladen durch eine Ladeschleuse (loadlock) aus einer Prozesskammer transferiert wird.

Verschiedene Methoden stehen zur Verfügung, um erwähnte Spuren auf der Vorderseite und/oder der Rückseite einer Halbleiterscheibe mit epitaktischer Schicht nachzuweisen. Beispielsweise beruht die Nachweis-Methode, die in US 2012/0 177 282 A1 und US 2012/0 179 419 A1 beschrieben ist, auf einer als Localized Feature Metrics (LFM) bezeichneten Auswertung von Topographie-Daten, die durch Interferometrie gewonnen werden. Damit können lokale Höhenkarten zur Nanotopographie der Vorderseite und der Rückseite einer Halbleiterscheibe mit epitaktischer Schicht erstellt werden. Maxima und Minima (peaks und valleys) im Höhenprofil können den erwähnten Spuren zugeordnet werden.

Die erwähnten Spuren können beispielsweise auch an Hand der Auswertung von Daten nachgewiesen werden, die auf Streuung von Laserlicht beruhen. Eine Vorrichtung, die diese Messmethode verwendet, ist beispielsweise in der US 2010/0 195 097 A1 beschrieben.

Des Weiteren ist auch der Nachweis mittels SIRD (Scanning Infra Red Depolarization) möglich, einer Methode, mittels derer Spannungen in der Halbleiterscheibe mit epitaktischer Schicht gemessen werden können. In der US 2004/0 021 097 A1 ist ein Verfahren zum Nachweis von Defekten auf Halbleiterscheiben mittels SIRD beschrieben.

Aufgabe der Erfindung ist es, das Verfahren zur Herstellung einer Halbleiterscheibe mit epitaktischer Schicht in einer Abscheidekammer zu verbessern.

Die Aufgabe der Erfindung wird gelöst durch ein Verfahren zur Herstellung einer Halbleiterscheibe mit epitaktischer Schicht in einer Abscheidekammer, umfassend das Ablegen einer Substratscheibe im Randbereich der Rückseite der Substratscheibe auf eine Ablagefläche eines Suszeptors in einer Schleusenkammer, wobei der Suszeptor als Ring ausgebildet ist;
das Beladen der Abscheidekammer mit dem Suszeptor und der auf dem Suszeptor liegenden Substratscheibe durch Kontaktieren nur des Suszeptors und Transportieren des Suszeptors und der auf dem Suszeptor liegenden Substratscheibe von der Schleusenkammer in die Abscheidekammer;
das Abscheiden einer epitaktischen Schicht auf der Substratscheibe;
das Entladen der Abscheidekammer durch Kontaktieren nur des Suszeptors und Transportieren des Suszeptors und einer, im Zuge des Abscheidens der epitaktischen Schicht entstandenen und auf dem Suszeptor liegenden Halbleiterscheibe mit epitaktischer Schicht aus der Abscheidekammer in die Schleusenkammer; und das Trennen des Suszeptors und der Halbleiterscheibe mit epitaktischer Schicht in der Schleusenkammer, gekennzeichnet durch
während des Abscheidens der epitaktischen Schicht auf der Substratscheibe das Bereitstellen einer weiteren Substratscheibe in der Schleusenkammer für den Transport der weiteren Substratscheibe in die Abscheidekammer.

Die Aufgabe wird ferner gelöst durch eine Vorrichtung zur Herstellung einer Halbleiterscheibe mit epitaktischer Schicht, umfassend
eine Abscheidekammer;
eine Schleusenkammer;
einen Suszeptor mit einer Ablagefläche zum Ablegen einer Substratscheibe im Randbereich der Rückseite der Substratscheibe, der als Ring ausgebildet ist;
in der Schleusenkammer Hebeelemente zum Anheben und Absenken des Suszeptors und einer auf dem Suszeptor liegenden Substratscheibe oder Halbleiterscheibe mit epitaktischer Schicht unter Kontaktierung des Suszeptors von unten;
ein während eines Transports nur den Suszeptor kontaktierendes Transportwerkzeug zum Transport des Suszeptors und einer auf dem Suszeptor liegenden Substratscheibe von der Schleusenkammer in die Abscheidekammer und zum Transport des Suszeptors und einer auf dem Suszeptor liegenden Halbleiterscheibe mit epitaktischer Schicht von der Abscheidekammer in die Schleusenkammer; Hebestifte zum Anheben der Halbleiterscheibe mit epitaktischer Schicht vom Suszeptor in der Schleusenkammer; und
obere und untere Halteklammern in der Schleusenkammer zum Halten der Substratscheibe und der Halbleiterscheibe mit epitaktischer Schicht.

Durch die Erfindung ist eine Halbleiterscheibe mit epitaktischer Schicht zugänglich, aufweisend eine Vorderseite, eine Rückseite und einen Rand, wobei auf der Vorderseite und der Rückseite außerhalb eines Randausschlusses von 1 mm weder ein Pin-Mark-Defekt nachweisbar ist, noch ein Defekt, der die Abbildung eines Spalts darstellt, und am Rand keine Beschädigung mit einer Tiefe von mehr als 100 nm vorhanden ist.

Vorzugsweise ist am Rand der Halbleiterscheibe mit epitaktischer Schicht keine Beschädigung mit einer Tiefe von mehr als 50 nm vorhanden.

Die Vorderseite und die Rückseite dieser Halbleiterscheibe mit epitaktischer Schicht sind also frei von Spuren, die belegen, dass die Halbleiterscheibe während des Abscheidens der epitaktischen Schicht über Bohrungen mit Hebestiften und/oder über einem Spalt im Suszeptor angeordnet war, und der Rand der Halbleiterscheibe mit epitaktischer Schicht ist frei von Druckstellen eines Handhabungswerkzeugs.

Unterschiedliches Wärmeausdehnungs-Verhalten von Substratscheibe und Suszeptor kann dazu führen, dass beim Erhitzen der Substratscheibe und des Suszeptors auf Abscheidetemperatur eine Relativbewegung von Substratscheibe und Suszeptor ausgelöst wird. Diese Relativbewegung ist jedoch geringfügig und eine gegebenenfalls nachweisbare Spur der Relativbewegung auf der Rückseite der Halbleiterscheibe mit epitaktischer Schicht bleibt innerhalb des Bereichs des Randausschlusses von 1 mm, hat also nicht mehr als 1 mm Abstand zum Rand der Halbleiterscheibe mit epitaktischer Schicht.

Ein Pin-Mark-Defekt oder ein Defekt, der die Abbildung eines Spalts darstellt, hat eine radiale Ausdehnung von nicht mehr als 15 mm und eine Höhenabweichung zu seiner Umgebung von mindestens ± 5 nm.

Die Präsenz solcher Defekte ist beispielsweise nachweisbar durch LFM-Auswertung von Messdaten eines Metrologie-Systems vom Typ WaferSight 2 von KLA Tencor oder erkennbar auf einer Haze-Karte eines Surfscan® SP3 Inspektionssystems von KLA Tencor oder sichtbar auf einer Nanotopographie-Karte eines Inspektionssystems vom Typ AWX™ von Rudolph Technologies oder auf einer SIRD-Karte eines Systems von PVA TePIa.

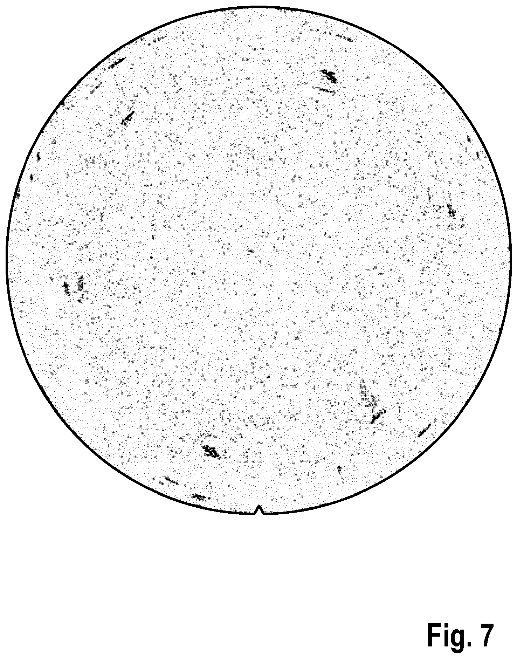

Fig.7 zeigt stellvertretend eine gestapelte Nanotopographie-Karte, auf der Sätze von je drei Pin-Mark-Defekten zu sehen sind, wobei die Pin-Mark-Defekte eines Satzes einen radialen Abstand von ungefähr 120° zum jeweiligen Nachbarn haben.

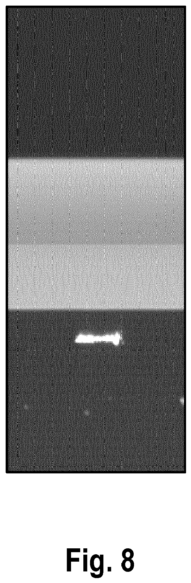

Die Präsenz einer Beschädigung am Rand der Halbleiterscheibe mit epitaktischer Schicht, die durch ein Handhabungswerkzeug verursacht wird, das nach dem Bernoulli-Prizip arbeitet, kann beispielsweise durch Inspektion mittels AFM oder mit Hilfe eines Konfokalmikroskops belegt werden. Die Aufnahme gemäß Fig.8 zeigt eine solche Beschädigung.

Eine durch die Erfindung zugängliche Halbleiterscheibe mit epitaktischer Schicht ist vorzugsweise eine Halbleiterscheibe aus einkristallinem Silizium mit einer epitaktischen Schicht aus
einkristallinem Silizium. Sie resultiert durch Abscheiden einer epitaktischen Schicht auf einer Substratscheibe aus einkristallinem Silizium mit vorzugsweise polierter Vorderseite und polierter Rückseite. Die Politur der Substratscheibe erfolgt vorzugsweise durch gleichzeitiges Polieren von deren Vorderseite und Rückseite, also durch Doppelseitenpolitur (DSP). Der Durchmesser der Halbleiterscheibe mit epitaktischer Schicht beträgt vorzugsweise nicht weniger als 200 mm, besonders bevorzugt nicht weniger als 300 mm.

Die Erfindung bringt einige Vorteile mit sich. In der Abscheidekammer brauchen keine Hebestifte zum Anheben der Substratscheibe oder der Halbleiterscheibe mit epitaktischer Schicht und dafür notwendige Bohrungen im Suszeptor vorgesehen werden. Ein erhebliches Verrutschen der Substratscheibe aus der vorgesehenen, zum Suszeptor konzentrischen Position (out-of-pocket-Situation) ist nahezu ausgeschlossen. Eine nach dem Verfahren hergestellte Halbleiterscheibe mit epitaktischer Schicht zeichnet sich durch eine besondere Güte der Vorderseite, der Rückseite und des Rands aus.

Diese Vorteile resultieren insbesondere dadurch, dass die Substratscheibe und der Suszeptor beziehungsweise die Halbleiterscheibe mit epitaktischer Schicht und der Suszeptor von der Schleusenkammer in die Abscheidekammer beziehungsweise aus der Abscheidekammer in die Schleusenkammer als eine Einheit mit einem Transportwerkzeug transportiert werden. Das Transportwerkzeug hält die Einheit während des Transportvorgangs nur am Suszeptor. Die Substratscheibe beziehungsweise die Halbleiterscheibe mit epitaktischer Schicht hat während des Transports der Einheit nur Kontakt zum Suszeptor. Der Suszeptor ist als Ring ausgebildet und weist am inneren Rand des Suszeptors eine Ablagefläche auf, auf der die Substratscheibe beziehungsweise die Halbleiterscheibe mit epitaktischer Schicht in einem Randbereich von deren jeweiliger Rückseite aufliegt. Der Ring hat vorzugsweise eine in US 2008/0 118 712 A1 beschriebene Form und weist die dort beschriebenen Abmessungen und Materialeigenschaften auf. Bevorzugt ist auch, den Ring in der Abscheidekammer auf eine Bodenplatte zu legen, so dass der Ring und die Bodenplatte einen zweiteiligen Suszeptor bilden. Die Bodenplatte hat vorzugsweise die in US 2008/0 118 712 A1 beschriebenen Abmessungen und Materialeigenschaften.

Die Substratscheibe wird in einer Schleusenkammer durch ein Handhabungswerkzeug so angeordnet, dass sie auf dem Ring abgelegt werden kann. Nachdem sie auf dem Ring abgelegt worden ist, wird die Substratscheibe auf dem Ring liegend durch ein Transportwerkzeug von der Schleusenkammer in die Abscheidekammer transportiert. Das Transportwerkzeug hat während des Transports Kontakt zum Ring, aber keinen Kontakt zur Substratscheibe. In der Abscheidekammer wird der Ring auf Hebestifte abgelegt und die Hebestifte, die Kontakt zum Ring aber keinen Kontakt zur Substratscheibe haben, werden in eine Abscheideposition abgesenkt. In der Abscheideposition liegt der Ring vorzugsweise auf einer Bodenplatte und bildet mit dieser einen zweiteiligen Suszeptor.

Nach dem Abscheiden einer epitaktischen Schicht auf der Substratscheibe wird die resultierende Halbleiterscheibe mit epitaktischer Schicht zusammen mit dem Ring von den Hebestiften angehoben und an das Transportwerkzeug übergeben. Wieder berühren die Hebestifte nur den Ring und nicht die auf dem Ring liegende Halbleiterscheibe mit epitaktischer Schicht und wieder hat das Transportwerkzeug während des Transports des Rings und der auf dem Ring liegenden Halbleiterscheibe mit epitaktischer Schicht von der Abscheidekammer in die Schleusenkammer Kontakt zum Ring, aber keinen Kontakt zur Halbleiterscheibe mit epitaktischer Schicht. Beim Entladen der Abscheidekammer beträgt die Temperatur der Halbleiterscheibe mit epitaktischer Schicht vorzugsweise nicht weniger als 650 °C, besonders bevorzugt nicht weniger als 700 °C.

Auf Grund der geschilderten Vorgehensweise beträgt in der Abscheidekammer der Temperaturunterschied zwischen der Temperatur der Substratscheibe beziehungsweise der Halbleiterscheibe mit epitaktischer Schicht und der Temperatur des Rings nicht mehr als 50 °C, vorzugsweise nicht mehr als 20 °C.

Die Einheit von Ring und darauf liegender Halbleiterscheibe mit epitaktischer Schicht wird in der Schleusenkammer getrennt. Zu diesem Zeitpunkt hat die Halbleiterscheibe mit epitaktischer Schicht eine Temperatur, die deutlich niedriger ist, als deren Temperatur zum Zeitpunkt unmittelbar nach dem Abscheiden der epitaktischen Schicht. Dementsprechend ist der Kontakt zu Hebestiften weniger kritisch. Wegen der niedrigeren Temperatur können im Hinblick auf Materialien, die Kontakt zur Halbleiterscheibe mit epitaktischer Schicht haben dürfen, auch solche in Betracht gezogen werden, die erst bei vergleichsweise niedrigen Temperaturen stabil sind, wie beispielsweise Kunststoffe. Solche Materialien haben in der Regel auch einen vergleichsweise geringen Härtegrad. Die Verwendung solcher Materialien ist bevorzugt, weil damit die Rückseite der Halbleiterscheibe mit epitaktischer Schicht berührt und dennoch zuverlässig vor mechanischer Beschädigung bewahrt werden kann.

In der Schleusenkammer wird die Halbleiterscheibe mit epitaktischer Schicht durch Hebestifte vom Ring angehoben und nach dem Ausfahren des Transportwerkzeugs und des von diesem gehaltenen Rings aus der Schleusenkammer vorzugsweise auf einem kühlenden Block am Boden der Schleusenkammer durch Absenken der Hebestifte abgelegt und weiter abgekühlt. Erfindungsgemäß wird zu diesem Zeitpunkt in der Schleusenkammer bereits eine Substratscheibe für einen neuen Abscheidezyklus vorbereitet. So kann das Transportwerkzeug mit dem Ring wieder in die Schleusenkammer Einfahren und der neue Abscheidezyklus begonnen werden, indem die vorbereitete Substratscheibe auf dem Ring abgelegt wird für den sich daran anschließenden gemeinsamen Transport von Ring und auf dem Ring liegender Substratscheibe in die Abscheidekammer.

Während des Abscheidens einer epitaktischen Schicht auf der vorbereiteten Substratscheibe wird die abgekühlte Halbleiterscheibe mit epitaktischer Schicht durch Hebestifte vom kühlenden Block angehoben, dem Handhabungswerkzeug übergeben und von der Schleusenkammer in einen Transportbehälter überführt, um Platz für die, im neuen Abscheidezyklus entstehende Halbleiterscheibe mit epitaktischer Schicht zu schaffen.

Besonders bevorzugte Merkmale der Erfindung werden nachfolgend unter Bezugnahme auf Zeichnungen beschrieben.

Die bezüglich der vorstehend aufgeführten Ausführungsformen des erfindungsgemäßen Verfahrens angegebenen Merkmale können entsprechend auf die erfindungsgemäße Vorrichtung übertragen werden. Umgekehrt können die bezüglich der vorstehend ausgeführten Ausführungsformen der erfindungsgemäßen Vorrichtung angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

### Kurzbeschreibung der Figuren

Fig. 1 zeigt eine erfindungsgemäße Vorrichtung zur Herstellung einer Halbeiterscheibe mit epitaktischer Schicht.
Fig.2 zeigt eine Schleusenkammer mit erfindungsgemäßen Merkmalen.
Fig.3 zeigt die Schleusenkammer in Draufsicht.
Fig.4 zeigt Merkmale der Abscheidekammer, die im Zusammenhang mit der Erfindung stehen.
Fig.5 zeigt die Schleusenkammer im Querschnitt in einer Situation mit einer Substratscheibe.
Fig.6 zeigt die Schleusenkammer in perspektivischer Ansicht in einer Situation mit einer Halbleiterscheibe mit epitaktischer Schicht.
Fig.7 zeigt Pin-Mark-Defekte auf der Rückseite einer Halbleiterscheibe mit epitaktischer Schicht.
Fig.8 zeigt eine Beschädigung am Rand einer Halbleiterscheibe mit epitaktischer Schicht, verursacht durch ein Hebewerkzeug, das nach dem Bernoulli-Prinzip arbeitet.

### Liste der verwendeten Bezugszeichen

- **1**: Halbleiterscheibe mit epitaktischer Schicht
- **2**: Abscheidekammer
- **3**: Schleusenkammer
- **4**: Substratscheibe
- **5**: Ring
- **7**: Transportwerkzeug
- **8**: Endeffektor
- **9**: Zugangsschlitze
- **10**: Roboter
- **11**: Handhabungswerkzeug
- **12**: obere Halteklammern
- **13**: untere Halteklammern
- **14**: kühlender Block
- **15**: innere Hebestifte
- **16**: äußere Hebeelemente
- **17**: Kopf
- **18**: Erhöhung
- **19**: Stützeinrichtung
- **20**: Bodenplatte
- **21**: Hebestifte
- **22**: tief liegender Bereich der Kopfes
- **23**: Ablagefläche

### Detaillierte Beschreibung erfindungsgemäßer Ausführungsbeispiele

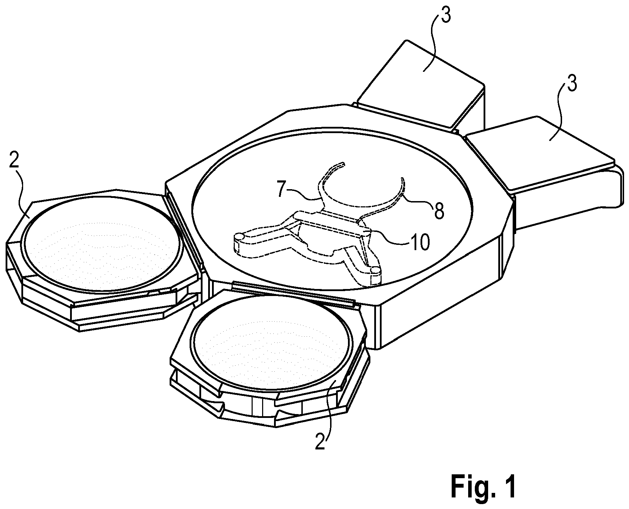

Fig. 1 zeigt eine erfindungsgemäße Vorrichtung zur Herstellung einer Halbeiterscheibe mit epitaktischer Schicht. Dargestellt ist ein Ausführungsbeispiel mit zwei Schleusenkammern 3 und zwei Abscheidekammern 2, die um ein

Transportwerkzeug 7 gruppiert sind. Das Transportwerkzeug 7 ist im Wesentlichen ein Endeffektor 8, der an einem Roboter 10 befestigt ist. Der Endeffektor 8 hat Finger zum Tragen eines Suszeptors. Der Roboter 10 ist so ausgestaltet, dass der Endeffektor 8 in eine Schleusenkammer 3 eingefahren und dort angehoben und abgesenkt werden kann.

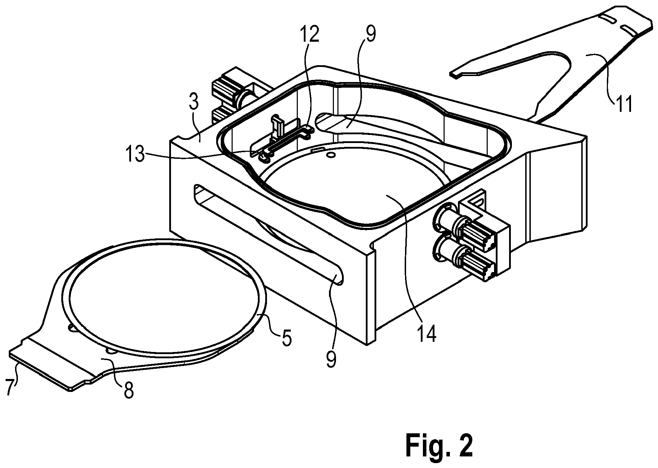

Die Schleusenkammer 3 gemäß Fig.2 hat Zugangsschlitze 9 für das Transportwerkzeug 7 und ein Handhabungswerkzeug 11, die sich gegenüberliegen und als besonderes Merkmal horizontal bewegliche, obere und untere Halteklammern 12, 13. Die oberen und unteren Halteklammern 12, 13 bilden jeweils ein Paar von Halteklammern, die sich gegenüberliegend angeordnet sind. Jedes Paar von Halteklammern kann von einer Freigabeposition in eine Halteposition bewegt werden. In der Freigabeposition sind die Halteklammern eines Paares in einem inaktiven Zustand und voneinander nach außen weggezogen. In der Halteposition befinden sie sich in einem aktiven Zustand. Sie sind aufeinander zu bewegt und haben einen Abstand zueinander, der ihnen ermöglicht, eine von oben abgelegte Scheibe zentrierend aufnehmen und halten können. Die oberen Halteklammern 12 sind zur Aufnahme und zum Halten einer Substratscheibe vorgesehen und die unteren Halteklammern 13 zur Aufnahme und zum Halten einer Halbleiterscheibe mit epitaktischer Schicht. Fig.2 zeigt auch den Endeffektor 8 des Transportwerkzeugs 7 mit darauf abgelegtem Suszeptor, der als Ring 5 ausgebildet ist, und ein Handhabungswerkzeug 11 mit der Form einer Schaufel, auf der eine Scheibe zentriert abgelegt werden kann. Den Boden der Schleusenkammer bildet ein kühlender Block 14 mit vorzugsweise zylindrischer Form.

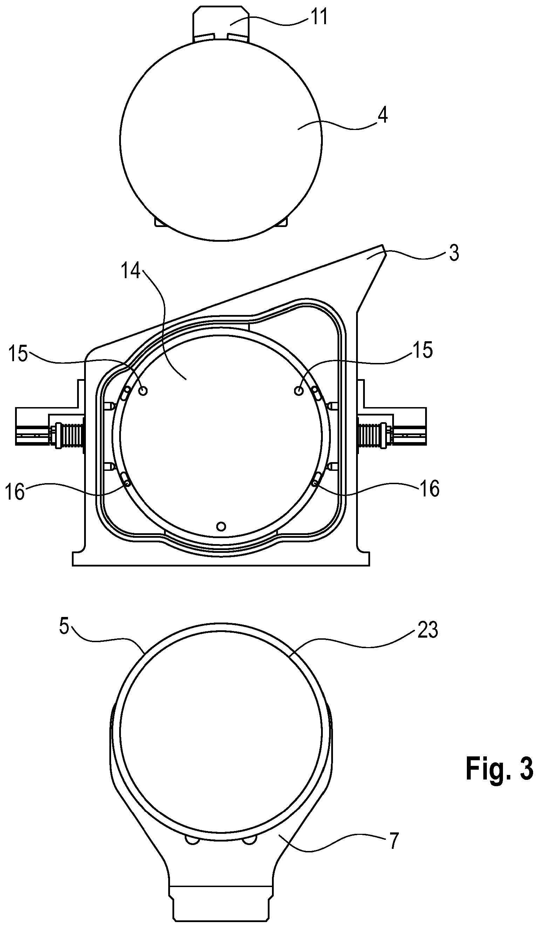

In Fig.3 ist der kühlende Block 14 in Draufsicht zu sehen. Es ist vorgesehen, eine Halbleiterscheibe mit epitaktischer Schicht auf der oberen Seite des kühlenden Blocks 14 zum Abkühlen abzulegen. Der kühlende Block 14 hat Bohrungen zur Aufnahme äußerer Hebeelemente 16 und innerer Hebestifte 15. Die Bohrungen für die inneren Hebestifte 15 haben einen geringeren Abstand zur Mitte des kühlenden Blocks 14, als die Bohrungen für die äußeren Hebeelemente 16. Sie sind ausreichend weit vom Rand des kühlenden Blocks 14 angeordnet, damit beim Anheben der inneren Hebestifte 15 ein Kontakt mit dem Ring 5, dem Handhabungswerkzeug 11 oder dem Transportwerkzeug 7 ausgeschlossen ist. Hinsichtlich ihrer radialen Position sind die Bohrungen für die inneren Hebestifte 15 vorzugsweise versetzt zu den Bohrungen für die äußeren Hebeelemente 16 angeordnet, die Bohrungen liegen also auf unterschiedlichen Radien. Vorzugsweise sind mindestens drei äußere Hebeelemente 16 und mindestens drei innere Hebestifte 15 vorhanden. Darüber hinaus zeigt Fig.3 das Handhabungswerkzeug 11 mit darauf abgelegter Substratscheibe 4 und das Transportwerkzeug 7 mit darauf abgelegtem Ring 5, der eine Ablagefläche 23 zum Ablegen einer Substratscheibe 4 aufweist.

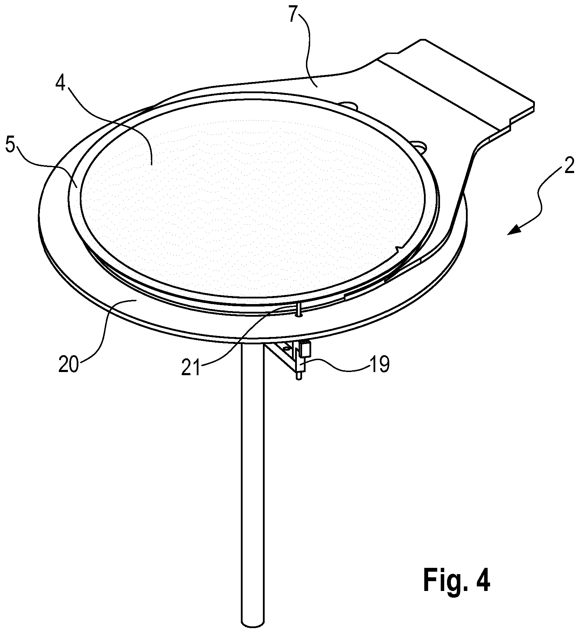

Die Abscheidekammer umfasst Merkmale eines üblichen Einzelscheibenreaktors zur Gasphasenabscheidung, vorzugsweise eines Einzelscheibenreaktors vom Typ EPI CENTURA® des Herstellers Applied Materials oder eines Einzelscheibenreaktors des Herstellers Advanced Semiconductor Materials. Dementsprechend sind in Fig.4 nur Merkmale gezeigt, die zum Verständnis der Erfindung beitragen und/oder solche, die Merkmale der vorliegenden Erfindung sind. Die Abscheidekammer 2 umfasst eine Stützeinrichtung 19 zum Abstützen eines Suszeptors. Gemäß der dargestellten, bevorzugten Ausführungsform ist die Stützeinrichtung 19 ausgelegt zum Abstützen eines zweiteiligen Suszeptors bestehend aus einem Ring 5 und einer Bodenplatte 20. Der Ring 5 kann auf der Bodenplatte 20 abgelegt werden und ist im abgelegten Zustand vorzugsweise in der Bodenplatte 20 eingebettet. Die Stützeinrichtung 19 umfasst vertikal bewegliche Hebestifte 21, die derart ausgestaltet sind, dass sie beim Anheben den Ring 5 von unten kontaktieren. Der Abscheidekammer 2 fehlen jedoch vertikal bewegliche Hebestifte, die die Substratscheibe 4 oder die Halbleiterscheibe mit epitaktischer Schicht kontaktieren und anheben.

Im Folgenden wird der Ablauf des Verfahrens der Herstellung einer Halbleiterscheibe mit epitaktischer Schicht beschrieben.

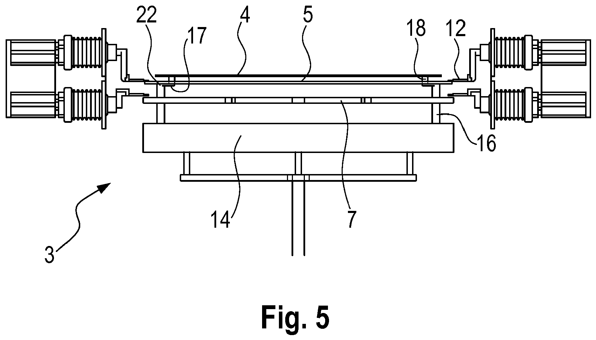

Zunächst wird die Schleusenkammer 3 mit einer Substratscheibe 4 und einem Ring 5 beladen, wobei im Verlauf des Beladens die in Fig.5 im Querschnitt gezeigte Anordnung zu Stande kommt. Es werden erst die oberen Halteklammern 12 der Schleusenkammer 3 in die Halteposition gebracht und anschließend oder gleichzeitig eine auf dem Handhabungswerkzeug 11 liegende Substratscheibe 4 in eine Ablageposition über den oberen Halteklammern 12 bewegt, indem das Handhabungswerkzeug 11 mit der Substratscheibe 4 durch den Zugangsschlitz 9 in die Schleusenkammer 3 bis zur Ablageposition einfährt. Daraufhin wird die Substratscheibe 4 auf den oberen Halteklammern 12 abgelegt, indem das Handhabungswerkzeug 11 unter das Niveau der oberen Halteklammern 12 abgesenkt wird. Nachdem die Substratscheibe 4 auf den oberen Halteklammern 12 liegt, wird das Handhabungswerkzeug 11 durch den Zugangsschlitz 9 aus der Schleusenkammer 3 zurückgezogen. Die äußeren Hebeelemente 16 sind drehbar und haben jeweils einen, zu einem Haken abgewinkelten Kopf 17, der durch Schwenken des äußeren Hebeelements 16 zwischen einer tangentialen und einer radialen Position wechseln kann. Das Ende des abgewinkelten Kopfes 17 ist durch eine stiftartige Erhöhung 18 nach oben verlängert. In der radialen Position des Kopfes 17 befindet sich die Erhöhung 18 weiter innen als der tief liegende Bereich 22 des Kopfes 17, der an die Erhöhung 18 angrenzt. Die Erhöhung 18 wird zum Anheben und Absenken einer Substratscheibe 4 eingesetzt, der angrenzende tiefliegende Bereich 22 des Kopfes 17 zum Anheben und Absenken eines als Suszeptor eingesetzten Rings 5.

Das Transportwerkzeug 7, auf dem ein Ring 5 liegt, fährt durch den Zugangsschlitz 9 in die Schleusenkammer 3 in eine Position, in der der Ring 5 konzentrisch unter der Substratscheibe 4 liegt. Dann werden die äußeren Hebeelemente 16 angehoben und jeder Kopf 17 der äußeren Hebeelemente 16 aus der tangentialen Position in die radiale Position geschwenkt. Die äußeren Hebeelemente 16 werden dann weiter angehoben, bis die Substratscheibe 4 von den oberen Halteklammern 12 und, etwas später, der Ring 5 vom Transportwerkzeug 7 gehoben worden sind, wobei die Köpfe 17 der äußeren Hebeelemente 16 den Ring 5 mit dem jeweiligen tief liegenden Bereich 22 eines Kopfes 17 und die Substratscheibe 5 mit der jeweiligen Erhöhung 18 eines Kopfes 17 anheben. Daraufhin werden die oberen Halteklammern 12 in die Freigabeposition zurückgezogen. Fig.5 zeigt die dann erreichte Anordnung im Querschnitt.

Anschließend werden die äußeren Hebeelemente 16 abgesenkt und im Zuge dessen der Ring 5 auf das Transportwerkzeug 7 zurückgelegt und die Substratscheibe 4 mit dem Randbereich von deren Rückseite auf der Ablagefläche 23 des Rings 5 abgelegt. Danach werden die Köpfe 17 der äußeren Hebeelemente 16 in die tangentiale Position zurückgeschwenkt und die äußeren Hebeelemente 16 in eine Ruheposition abgesenkt, in der die Köpfe 17 im kühlenden Block 14 eingelassen sind. Das Transportwerkzeug 7 wird zusammen mit dem Ring 5 und der auf dem Ring 5 liegenden Substratscheibe 4 durch den Zugangsschlitz 9 der Schleusenkammer 3 aus der Schleusenkammer 3 in die Abscheidekammer 2 überführt. Das Transportwerkzeug 7 hat keinen direkten Kontakt zur Substratscheibe 4.

In der Abscheidekammer 2 wird der Ring 5 in eine Position gebracht, von der aus er durch Hebestifte 21 angehoben werden kann. Im in Fig.4 dargestellten Ausführungsbeispiel wird der Ring 5 vom Transportwerkzeug 7 über einer Bodenplatte 20 gehalten, die mit dem Ring 5 einen zweiteiligen Suszeptor bildet. Der Ring 5 ist konzentrisch zur Bodenplatte 20 angeordnet. Die durch die Bodenplatte 20 führenden Hebestifte 21 werden aus einer Ruhelage vertikal angehoben, bis sie den Ring 5 und die darauf liegende Substratscheibe 4 vom Transportwerkzeug 7 gehoben haben. Die Hebestifte 21 kontaktieren den Ring 5 von unten und sind so ausgeführt, dass sie keinen Kontakt zur Substratscheibe 4 herstellen können. Fig.4 zeigt die Anordnung in perspektivischer Ansicht.

Als nächstes werden das Transportwerkzeug 7 aus der Abscheidekammer 2 gezogen und die Hebestifte 21 abgesenkt, bis der Ring 5 auf der Bodenplatte 20 liegt. Anschließend wird auf der Vorderseite der Substratscheibe 4 eine epitaktische Schicht abgeschieden. Danach werden die Hebestifte 21 wieder angehoben. Sie kontaktieren die untere Seite des Rings 5 und heben den Ring 5 und die darauf liegende Halbleiterscheibe mit epitaktischer Schicht von der Bodenplatte 20. Die Bewegung des Rings 5 mit abgelegter Halbleiterscheibe mit epitaktischer Schicht erfolgt spiegelbildlich zur vorangegangenen Bewegung des Rings 5 mit abgelegter Substratscheibe 4.

Der Ring 5 wird angehoben und das Transportwerkzeug 7 wird in die Abscheidekammer 2 zurückgebracht und unter dem Ring 5 in konzentrischer Lage zum Ring 5 angeordnet. Die Hebestifte 21 werden in ihre Ruhelage zurückgefahren und legen dabei den Ring 5 und die auf dem Ring 5 liegende Halbleiterscheibe mit epitaktischer Schicht auf dem Transportwerkzeug 7 ab. Die Zeit während des Abscheidens der epitaktischen Schicht auf der Substratscheibe wird genutzt, um die Schleusenkammer 3 mit einer weiteren zu beschichtenden Substratscheibe 4 zu beladen.

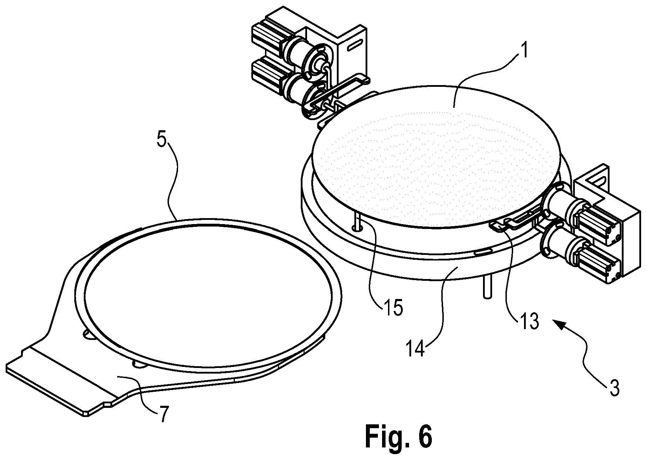

Das Transportwerkzeug 7 überführt den Ring 5 mit der darauf liegenden Halbleiterscheibe mit epitaktischer Schicht 1 in die Schleusenkammer 3 und zwar in eine vertikale Position unter den unteren Halteklammern 13 und konzentrisch zur vorbereiteten, zu beschichtenden Substratscheibe 4. Nun werden die inneren Hebestifte 15 angehoben, bis sie die Halbleiterscheibe mit epitaktischer Schicht 1 auf deren Rückseite kontaktieren und vom Ring 5 abheben. Daraufhin werden die unteren Halteklammern 13 von der Freigabeposition in die Halteposition verschoben, und die inneren Hebestifte 15 zurück in ihre Ausgangslage gefahren. Im Zuge dessen wird die Halbleiterscheibe mit epitaktischer Schicht 1 auf den unteren Halteklammern 13 abgelegt. Als nächstes wird das Transportwerkzeug 7 zusammen mit dem darauf abgelegten Ring 5 aus der Schleusenkammer 3 gefahren. Die inneren Hebestifte 15 werden nun erneut angehoben, bis sie die Halbleiterscheibe mit epitaktischer Schicht 1 von den unteren Halteklammern 13 heben. Fig.6 zeigt die sich dann ergebende Anordnung in perspektivischer Ansicht, wobei die vorbereitete zu beschichtende Substratscheibe aus Gründen der Vereinfachung weggelassen ist. Anschließend werden die unteren Halteklammern 13 in die Freigabeposition zurückgezogen und die inneren Hebestifte 15 wieder zurück in ihre Ausgangslage abgesenkt, wodurch die Halbleiterscheibe mit epitaktischer Schicht 1 auf dem kühlenden Block 14 abgelegt wird.

Die inneren Hebestifte 15 werden auch eingesetzt, um nach dem Abkühlen die Halbleiterscheibe mit epitaktischer Schicht 1 vom kühlenden Block 14 zu heben und sie an das Handhabungswerkzeug 11 zu übergeben, um sie damit anschließend in einen Transportbehälter zu überführen.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

## Patentansprüche

1. Verfahren zur Herstellung einer Halbleiterscheibe mit epitaktischer Schicht (1) in einer Abscheidekammer (2), umfassend
das Ablegen einer Substratscheibe (4) im Randbereich der Rückseite der Substratscheibe auf eine Ablagefläche (23) eines Suszeptors in einer Schleusenkammer (3), wobei der Suszeptor als Ring ausgebildet ist;
das Beladen der Abscheidekammer (2) mit dem Suszeptor und der auf dem Suszeptor liegenden Substratscheibe durch Kontaktieren nur des Suszeptors und Transportieren des Suszeptors und der auf dem Suszeptor liegenden Substratscheibe von der Schleusenkammer (3) in die Abscheidekammer (2);
das Abscheiden einer epitaktischen Schicht auf der Substratscheibe;
das Entladen der Abscheidekammer (2) durch Kontaktieren nur des Suszeptors und Transportieren des Suszeptors und einer, im Zuge des Abscheidens der epitaktischen Schicht entstandenen und auf dem Suszeptor liegenden Halbleiterscheibe mit epitaktischer Schicht (1) aus der Abscheidekammer (2) in die Schleusenkammer (3); **gekennzeichnet durch** das Trennen des Suszeptors und der Halbleiterscheibe mit epitaktischer Schicht (1) in der Schleusenkammer (3), durch während des Abscheidens der epitaktischen Schicht auf der Substratscheibe das Bereitstellen einer weiteren Substratscheibe in der Schleusenkammer (3) für den Transport der weiteren Substratscheibe in die Abscheidekammer (2).

2. Verfahren nach Anspruch 1, umfassend das Entladen der Abscheidekammer (2) zu einem Zeitpunkt, bei dem die Temperatur der Halbleiterscheibe mit epitaktischer Schicht (1) nicht weniger als 650 °C beträgt.

3. Vorrichtung zur Herstellung einer Halbleiterscheibe mit epitaktischer Schicht (1), umfassend
eine Abscheidekammer (2);
eine Schleusenkammer (3);
einen Suszeptor mit einer Ablagefläche (23) zum Ablegen einer Substratscheibe im Randbereich der Rückseite der Substratscheibe, der als Ring ausgebildet ist;
in der Schleusenkammer (3) Hebeelemente (16) zum Anheben und Absenken des Suszeptors und einer auf dem Suszeptor liegenden Substratscheibe oder Halbleiterscheibe mit epitaktischer Schicht (1) unter Kontaktierung des Suszeptors von unten; ein während eines Transports nur den Suszeptor kontaktierendes Transportwerkzeug (7) zum Transport des Suszeptors und einer auf dem Suszeptor liegenden Substratscheibe von der Schleusenkammer (3) in die Abscheidekammer (2) und zum Transport des Suszeptors und einer auf dem Suszeptor liegenden Halbleiterscheibe mit epitaktischer Schicht (1) von der Abscheidekammer (2) in die Schleusenkammer (3); **gekennzeichnet durch** Hebestifte (15) zum Anheben der Halbeiterscheibe mit
epitaktischer Schicht vom Suszeptor in der Schleusenkammer (3); und
obere und untere Halteklammern (12, 13) in der Schleusenkammer (3) zum Halten der Substratscheibe und der Halbleiterscheibe mit epitaktischer Schicht (1).

4. Vorrichtung nach Anspruch 3, **gekennzeichnet durch** einen zweiteiligen Suszeptor bestehend aus dem Suszeptor, der die Ablagefläche (23) umfasst, und einer Bodenplatte (20), die in der Abscheidekammer (2) angeordnet ist.

## Claims

1. Process for producing a semiconductor wafer with an epitaxial layer (1) in a deposition chamber (2), comprising
depositing of a substrate wafer (4) in the edge region of the rear side of the substrate wafer onto a depositing surface (23) of a susceptor in a load lock chamber (3), the susceptor being designed as a ring;
loading the deposition chamber (2) with the susceptor and the substrate wafer lying on the susceptor by contacting only the susceptor and transporting the susceptor and the substrate wafer lying on the susceptor from the load lock chamber (3) into the deposition chamber (2);
depositing an epitaxial layer on the substrate wafer;
unloading the deposition chamber (2) by contacting only the susceptor and transporting the susceptor and a semiconductor wafer with epitaxial layer (1), which was formed in the course of the deposition of the epitaxial layer and lies on the susceptor, from the deposition chamber (2) into the load lock chamber (3); **characterized by**
separating of the susceptor and the semiconductor wafer with epitaxial layer (1) in the load lock chamber (3), and
during the deposition of the epitaxial layer on the substrate wafer, providing a further substrate wafer in the load lock chamber (3) for the transport of the further substrate wafer into the deposition chamber (2).

2. The method according to claim 1, comprising unloading the deposition chamber (2) at a point in time when the temperature of the semiconductor wafer with epitaxial layer (1) is not less than 650°C.

3. Apparatus for producing a semiconductor wafer with an epitaxial layer (1), comprising
a deposition chamber (2);
a load lock chamber (3);
a susceptor with a deposition surface (23) for depositing a substrate wafer in the edge region of the rear side of the substrate wafer, the susceptor being formed as a ring;
in the load lock chamber (3), lifting elements (16) for raising and lowering the susceptor and a substrate wafer or semiconductor wafer with an epitaxial layer (1) lying on the susceptor by contacting of the susceptor from below; a transport tool (7) contacting only the susceptor during transport, for transporting the susceptor and a substrate wafer lying on the susceptor from the load lock chamber (3) into the deposition chamber (2) and for transporting the susceptor and a semiconductor wafer with epitaxial layer (1) lying on the susceptor from the deposition chamber (2) into the load lock chamber (3); **characterized by**
lifting pins (15) for lifting the semiconductor wafer with epitaxial layer from the susceptor in the load lock chamber (3); and
upper and lower holding clamps (12, 13) in the load lock chamber (3) for holding the substrate wafer and the semiconductor wafer with epitaxial layer (1).

4. Apparatus according to claim 3, **characterized by** a two-part susceptor consisting of the susceptor, which comprises the deposition surface (23), and a base plate (20), which is arranged in the deposition chamber (2).

## Revendications

1. Procédé de fabrication d'une plaquette de semi-conducteur avec une couche épitaxiale (1) dans une chambre de dépôt (2), comprenant
dépôt d'une plaquette de substrat (4) dans la région du bord de la face arrière de la plaquette de substrat sur une surface de dépôt (23) d'un suscepteur dans un sas (3), le suscepteur étant conçu comme un anneau;
charger la chambre de dépôt (2) avec le suscepteur et la plaquette de substrat reposant sur le suscepteur en ne mettant en contact que le suscepteur et transporter le suscepteur et la plaquette de substrat reposant sur le suscepteur du sas (3) dans la chambre de dépôt (2);
déposer d'une couche épitaxiale sur la plaquette de substrat;
décharger de la chambre de dépôt (2) en mettant en contact que le suscepteur et transporter le suscepteur et une plaquette de semi-conducteur avec la couche épitaxiale (1), qui a été formée au cours du dépôt de la couche épitaxiale et qui repose sur le suscepteur, de la chambre de dépôt (2) dans le sas (3), **caractérisée par**
séparer du suscepteur et de la plaquette semi-conductrice avec la couche épitaxiale (1) dans le sas (3), et
pendant le dépôt de la couche épitaxiale sur la plaquette de substrat, fournir une autre plaquette de substrat dans le sas (3) pour le transport de cette autre plaquette de substrat dans la chambre de dépôt (2).

2. Procédé selon la revendication 1, comprenant décharger de la chambre de dépôt (2) à un moment où la température de la plaquette de semi-conducteur avec la couche épitaxiale (1) n'est pas inférieure à 650°C.

3. Appareil pour la production d'une plaquette semi-conductrice avec une couche épitaxiale (1), comprenant
une chambre de dépôt (2);
un sas (3);
un suscepteur avec une surface de dépôt (23) pour déposer une plaquette de substrat dans la région du bord de la face arrière de la plaquette de substrat, le suscepteur étant formée en anneau;
dans le sas (3), des éléments de levage (16) pour soulever et abaisser le suscepteur et une plaquette de substrat ou de semi-conducteur avec une couche épitaxiale (1) reposant sur le suscepteur, le suscepteur étant en contact par le bas; un outil de transport (7) en contact uniquement avec le suscepteur pendant le transport pour transporter le suscepteur et une plaquette de substrat reposant sur le suscepteur du sas (3) dans la chambre de dépôt (2) et pour transporter le suscepteur et une plaquette de semi-conducteur avec une couche épitaxiale (1) reposant sur le suscepteur de la chambre de dépôt (2) dans le sas (3), **caractérisée par** des goupilles de levage (15) pour soulever la plaquette de semi-conducteur avec la couche épitaxiale du suscepteur dans le sas (3); et
des pinces de maintien supérieures et inférieures (12, 13) dans le sas (3) pour maintenir la plaquette de substrat et la plaquette de semi-conducteur avec couche épitaxiale (1).

4. Appareil selon la revendication 3, **caractérisé par** un suscepteur en deux parties composé du suscepteur, qui comprend la surface de dépôt (23), et d'une plaque de base (20), qui est disposée dans la chambre de dépôt (2).
